# EUROPÄISCHE PATENTSCHRIFT

(11) **EP 0 354 294 B1**
(45) Veröffentlichungstag und Bekanntmachung des Hinweises auf die Patenterteilung: **16.06.1993**
(21) Anmeldenummer: 89100845.0
(22) Anmeldetag: 19.01.1989
(51) Int. Cl.: C23C 14/56, C23C 14/50, H01L 21/00, H01J 37/20

(54) **Vorrichtung nach dem Karussell-Prinzip zum Beschichten von Substraten**
Carousel-type apparatus for coating substrates
Appareillage de type carrousel pour le revêtement de substrats

(30) Priorität: 12.08.1988 DE 3827343
(43) Veröffentlichungstag der Anmeldung: 14.02.1990
(73) Patentinhaber: LEYBOLD AKTIENGESELLSCHAFT, D-63450 Hanau (DE)
(72) Erfinder: Petz, Andreas, D-6454 Bruchköbel (DE); Costescu, Dan, D-6452 Hainburg (DE)

(56) Entgegenhaltungen:
- EP-A- 0 211 292
- EP-A- 0 244 202
- EP-A- 0 312 694
- WO-A-87/04414
- DE-A- 2 047 749

## Beschreibung

Die Erfindung betrifft eine Vorrichtung nach dem Karussell-Prinzip zum Beschichten von flachen, im wesentlichen kreisscheibenförmigen Substraten mit einer Vakuumkammer und einem in dieser angeordneten drehbaren Substrattransportring, der in gleichmaßigen Abständen und in kreisförmiger Anordnung eine Vielzahl von Substrataufnahmen aufweist und durch den eine entsprechende Anzahl von Substraten mittels eines Antriebs schrittweise auf einer Kreisbahn von zwei Schleusenstationen über zugeordnete Beschichtigungsstationen zur Schleusenstation zurück transportierbar ist, wobei die Schrittweite des Antriebs, die sich jeweils aus dem Abstand von zwei benachbarten Ausnehmungen des Substrattransportrings zueinander ergibt und der Abstand zweier Beschichtungsstation so gewählt sind, daß ein und dieselbe Beschichtungsstation über die schrittweise Bewegung jeweils einer bestimmten Substrataufnahme jeweils ein und derselben Schleusenstation zugeordnet ist.

Die Arbeitsweise einer solchen Vorrichtung kann wegen des Stillstandes zwischen den einzelnen Schritten, bedingt durch die Ein- und Ausschleusvorgänge sowie durch den stationären Beschichtungsvorgang als quasi kontinuierlich bezeichnet werden.

Durch die US-PS 3 652 444 ist eine Vorrichtung der eingangs beschriebenen Gattung bekannt, die drei Beschichtungsstationen, aber nur eine Schleusenstation aufweist. Die bekannte Vorrichtung ist für die Herstellung von Halbleitern vorgesehen, und üblicherweise dienen hierbei die verschiedenen Beschichtungsstationen zum Aufbringen einer ganzen Schichtenfolge. Den Beschichtungsstationen können andere Behandlungsstationen vor- und nachgeschaltet sein, in denen andere Behandlungsprozesse ablaufen, wie sie für die Vor- und Nachbehandlung von Halbleitern erforderlich sind. Bei gegebenem Teilkreisdurchmesser und entsprechenden Investitionskosten ist der Durchsatz jedoch begrenzt, schon weil das Ein- und Ausschleusen einschließlich des Evakuierens der Schleusenkammer entsprechende Zeit benötigen.

Nun gibt es eine Reihe von Beschichtungsaufgaben bzw. Produkten, bei denen der Beschichtungsprozeß selbst und/oder die Vor- und/oder Nachbehandlungen einen geringeren Zeitaufwand bedingen, so daß der Einsatz der bekannten Vorrichtung für derartige Prozesse bzw. Produkte außerordentlich unwirtschaftlich wäre. Ein Beispiel für solche Produkte sind die genannten CD-Platten, die nur auf einer Seite mit einer einzigen Schicht aus einem rasch aufzubringenden hochglänzenden Metall wie beispielsweise Aluminium zu versehen sind.

Weiterhin von Bedeutung sind beim Betrieb derartiger Vorrichtungen die sogenannten Beladestationen, mit denen eine vollautomatische Be- und Entladung solcher Vorrichtungen möglich ist. Derartige Beladestationen sind in Verbindung mit den zugehörigen Magazinstationen verhältnismäßig aufwendig und ihre Taktfrequenz kann infolge der relativ langsamen Arbeitsweise der bekannten Vorrichtung nicht voll ausgenutzt werden.

Um bei etwa vergleichbaren Investitionskosten den Durchsatz von in Frage stehenden Vorrichtungen wesentlich zu steigern, hat man in der zwischenveröffentlichten EP 0 312 694 auch bereits eine Vorrichtung nach dem Karussell-Prinzip mit einer Vakuumkammer und einem in dieser angeordneten drehbaren Substrathalter vorgeschlagen, der in äquidistanter Verteilung und in kreisförmiger Anordnung mehrere Substrataufnahmen aufweist und bei der die Vakuumkammer in Umfangsrichtung des drehbaren Substrathalters zwei Schleusenstationen und zwei Beschichtungsstationen jeweils hintereinander aufweist, wobei die Schrittweite des Antriebs einerseits und die Winkelstellung jeder Beschichtungsstation zu der ihr zugeordneten Schleusenstation in Bezug auf die Drehachse des Substrathalters andererseits so gewählt sind, daß ein und dieselbe Beschichtungsstation über die schrittweise Bewegung jeweils einer bestimmten Substrataufnahme jeweils ein und derselben Schleusenstation zugeordnet ist.

Der Erfindung liegt nun die Aufgabe zugrunde, eine Vorrichtung der eingangs beschriebenen Gattung dahingehend zu verbessern, daß der Durchsatz wesentlich gesteigert werden kann und sogenannte Totzeiten durch das Füllen bzw. Entleeren der Magazinstationen vermieden werden.

Erfindungsgemäß wird diese Aufgabe gelöst durch eine Vorrichtung nach dem Karussell-Prinzip zum Beschichten von flachen, im wesentlichen kreisscheibenförmigen Substraten mit einer Vakuumkammer und einem in dieser angeordneten drehbaren Substratransportring, der in gleichmäßigen Abständen und in kreisförmiger Anordnung eine Vielzahl von Substrataufnahmen aufweist und durch den eine entsprechende Anzahl von Substraten mittels eines Antriebs schrittweise auf einer Kreisbahn von mindestens einer Schleusenstation über zugeordneten Beschichtungsstationen zur selben Schleusenstation zurücktransportierbar ist, wobei die Schrittweite des Antriebs, die sich jeweils aus dem Abstand von zwei benachbarten Ausnehmungen des Substrattransportrings zueinander ergibt, und der Abstand zweier Beschichtungsstationen zueinander so gewählt sind, daß ein und dieselbe Beschichtungsstation über die schrittweise Bewegung jeweils einer bestimmten Substrataufnahme jeweils ein und derselben Schleusenstation zugeordnet ist und jeder Schleusenstation jeweils eine Übergabeeinrichtung mit jeweils einem drehbaren Substratteller mit Substrathaltern zugeordnet ist, wobei jeder Substratteller jeweils mit mehreren Magazinen bzw. Magazinhaltern zusammenwirkt, wobei jedes bzw. jeder Magazinhalter mindestens zwei Stapel oder Stapelkästen aufweist und wobei mit jedem der Magazine bzw. Magazinhalter oder Stapelkästen jeweils eine Wendeeinrichtung bzw. oder Substrat-Verschiebeeinrichtung zusammenwirkt, die die Substrate von den Stapeln zu den Substrathaltern der Substratteller oder umgekehrt transportiert, und jede der beiden Schleusenstationen jeweils eine Übergabeeinrichtung mit jeweils einem drehbaren Substratteller mit Substrathaltern zugeordnet ist, wobei jeder Substratteller jeweils mit mehreren Magazinen bzw. Magazinhaltern zusammenwirkt, wobei jedes Magazin bzw. jeder Magazinhalter mindestens zwei Stapel von Substraten oder Stapelkästen mit Substraten aufweist und wobei mit jedem der Magazine bzw. Magazinhalter oder Stapelkästen jeweils eine Wendeinrichtung oder Substratverschiebeeinrichtung zusammenwirkt, die die Substrate von den Stapeln zu den Substrathaltern der Substratteller oder umgekehrt transportiert.

Vorzugsweise wirken mit beiden Schleusenstationen Übergabeeinrichtungen zusammen, denen jeweils um die Drehachsen rotierende Substratteller mit jeweils einer Vielzahl von Substrathaltern zur Aufnahme von Substraten zugeordnet sind, wobei die Substrathalter in gleichmäßigen Abständen voneinander und auf einem Kreisbogen angeordnet sind und mittels eines Antriebs schrittweise bewegbar sind.

Weitere vorteilhafte Ausgestaltungen des Erfindungsgegenstandes ergeben sich aus den übrigen Unteransprüchen.

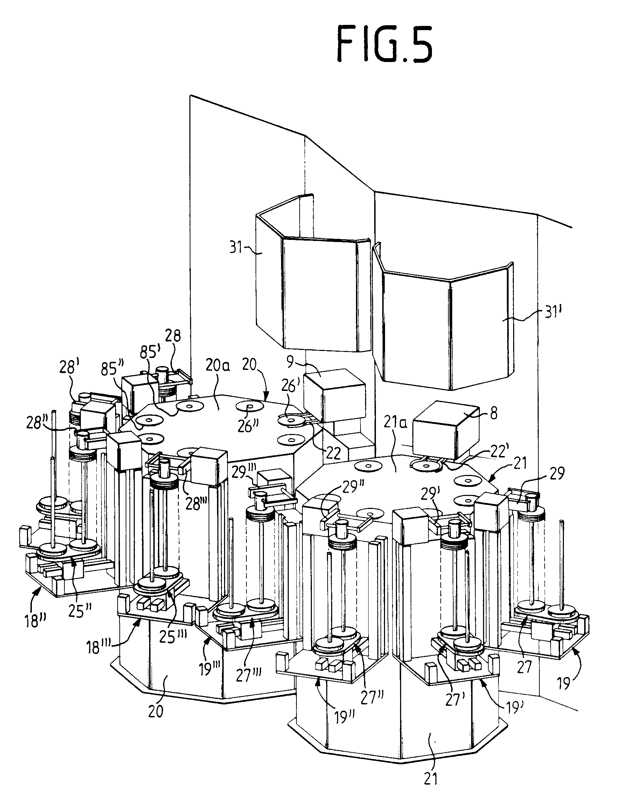

Ein Ausführungsbeispiel des Erfindungsgegenstandes wird nachfolgend anhand der Figuren 1 bis 5 näher erläutert.

Es zeigen:
- Figur 1: eine Draufsicht auf eine vollständige Vorrichtung nach der Erfindung
- Figur 2: eine Vorderansicht der Beschichtungsvorrichtung nach Figur 1 in Richtung des Pfeils II
- Figur 3: eine Draufsicht auf den Substrattransportring 6 der Beschichtungsvorrichtung
- Figur 4: einen Vertikalschnitt durch eine der beiden Schleusenstationen der Beschichtungsvorrichtung in vergrößertem Maßstab
- Figur 5: die perspektivische Ansicht der gesamten Vorrichtung mit Blick auf die beiden Übergabeeinrichtungen mit angehängten Magazinen

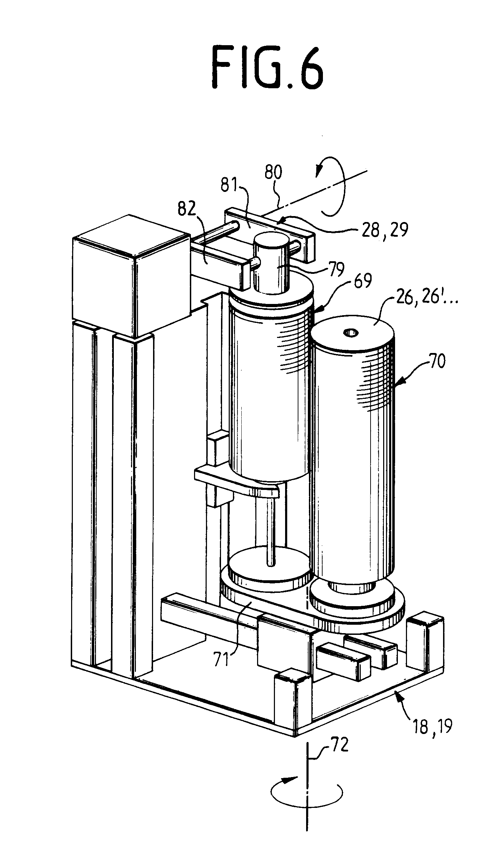

- Figur 6: Ein Magazin mit zwei Substrat-Stapeln und einer Wendeeinrichtung gemäß Figur 5 in vergrößertem Maßstab
- Figur 7: die perpektivische Ansicht einer Vorrichtung ähnlich derjenigen nach Figur 5, jedoch mit Magazinhaltern bzw. Stapelkästen.

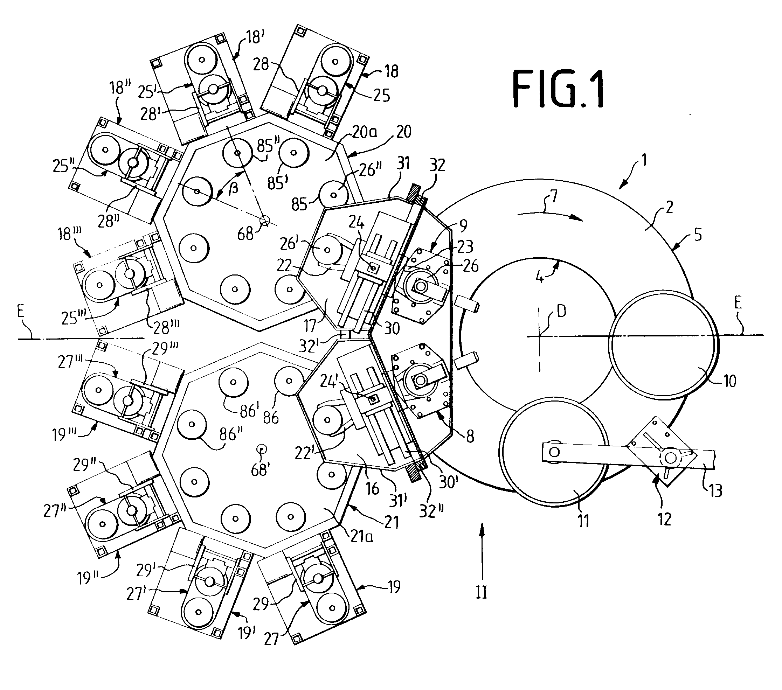

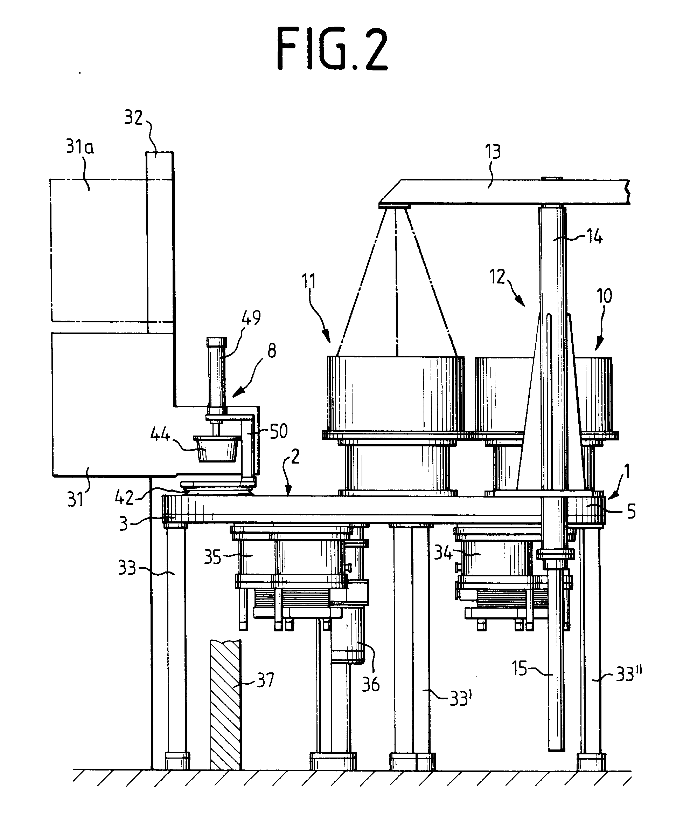

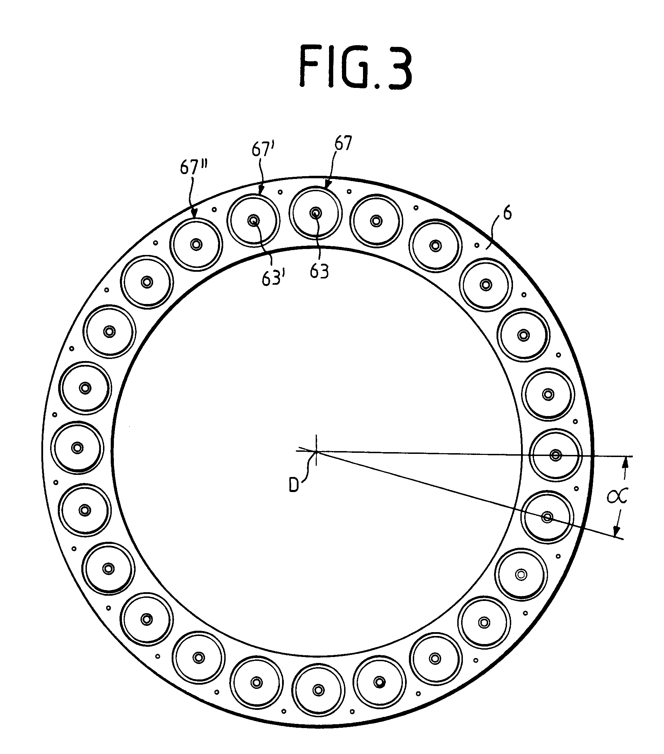

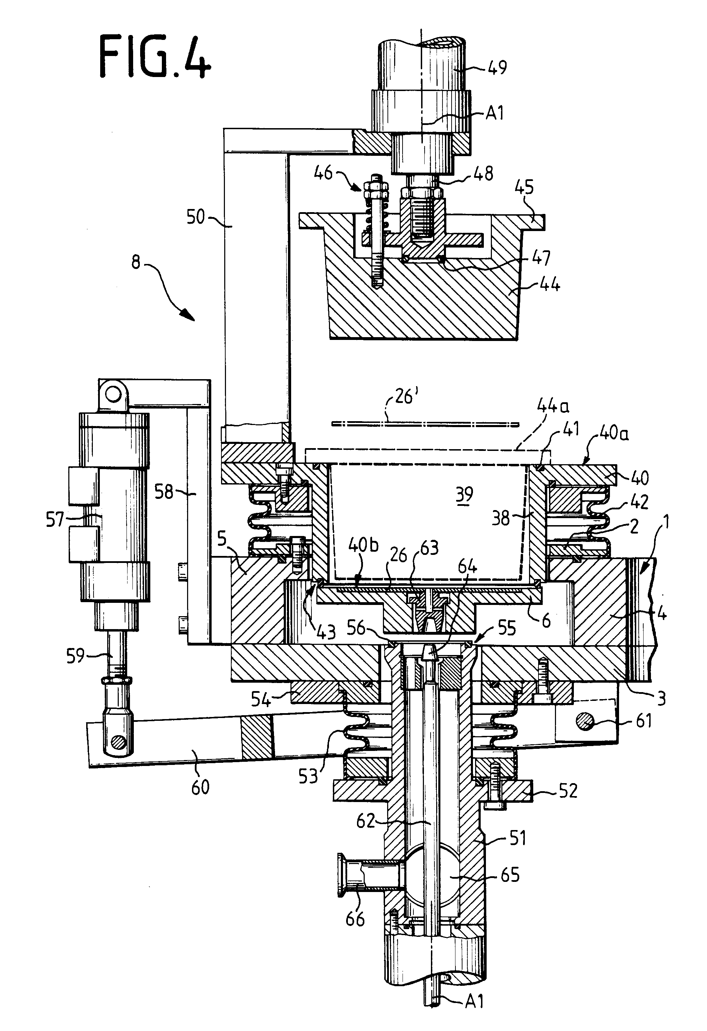

In Figur 1 ist eine Vakuumkammer 1 dargestellt, deren außere Hüllfläche als durch einen flachen Hohlzylinder gebildet beschrieben werden kann, d.h. eine obere kreisringförmige Kammerdecke 2 und ein kongruenter kreisringförmiger Kammerboden 3 sind durch eine innere Zarge 4 und eine äußere Zarge 5 miteinander verbunden. Die sehr flachen Abmessungen der Vakuumkammer 1 gehen insbesondere aus Figur 2 hervor. Im Innern der Vakuumkammer 1 ist ein gleichfalls kreisringförmiger Substrattransportring 6 drehbar und angetrieben untergebracht, worauf im Zusammenhang mit den Figuren 3 und 4 noch näher eingegangen wird. Die Anordnung muß jedoch nicht im Grundriß einem Kreisring entsprechen; vielmehr kann die Vakuumkammer auch zylindrisch ausgebildet sein.

Die Transportrichtung der Substrate wird durch den Pfeil 7 angedeutet. Die Vakuumkammer 1 ist mit zwei identischen Schleusenstationen 8 und 9 ausgestattet, auf die im Zusammenhang mit Figur 4 im Detail eingegangen wird. Auf der Oberseite der Vakuumkammer 1 sind ferner zwei Beschichtungsstationen 10 und 11 angeordnet.

Den Beschichtungsstationen 10 und 11 ist ein Hubmechanismus zugeordnet, der aus einem schwenkbaren Ausleger 13, einem Führungsrohr 14 und einem Hubzylinder 15 besteht und einen Wechsel der Kathoden ermöglichen soll.

Wie insbesondere in der Draufsicht in Figur 1 sichtbar wird, sind jeder Schleusenstation 8 bzw. 9 eine Beladestation 16 bzw. 17 und vier Magazine 18, 18', 18", 18"' bzw. 19, 19', 19", 19"' zugeordnet. Zwischen jeder Beladestation 16, 17 und den Magazinen 18, 18', ... bzw. 19, 19', ... ist eine Übergabeeinrichtung 20 bzw. 21 mit rotierendem Substratteller 20a bzw. 21a angeordnet.

Jede Beladestation 16, 17 weist jeweils zwei Greifer 22 und 23 bzw. 22' und 23' auf, die in diametral entgegengesetzten Richtungen jeweils an einer gemeinsamen Drehachse 24, 24' befestigt sind. Die Drehachse 24, 24' befindet sich jeweils in einer solchen Lage zur Übergabeeinrichtung 20 bzw. 21 einerseits und zur Schleusenstation 8 bzw. 9 andererseits, daß jeweils mittels des einen Greifers 23, 23' ein oberhalb der Schleusenstation 9 befindliches Substrat 26, 26' und mittels des anderen Greifers 22, 22' gleichzeitig ein oberhalb der Übergabeeinrichtung 20 befindliches Substrat 26", 26"' wahlweise erfaßbar oder absetzbar ist.

Jedes Magazin 18, 18', ... bzw. 19, 19', ... besitzt zwei als Magazinrevolver ausgebildete Substratstapel 25, 25', ... bzw. 27, 27', ... in dem jeweils zwei Stapel 69, 70 von Substraten 26, 26', ... untergebracht sind. Zum Magazin 18 bzw. 19 gehören jeweils noch eine Wendeeinrichtung 28, 28', ... bzw. 29, 29', ...

Im Hinblick auf die Drehbewegung der Greifer 22, 22' und 23, 23' sind deren Drehachse 24, 24' noch jeweils zwei Stoßdämpfer 30, 30' zugeordnet. Die Beladestationen 16 und 17 sind von Schutzhauben 31, 31' umgeben, und die gesamte Anordnung ist im Hinblick auf eine vertikale Symmetrieebene E-E (Figur 1) spiegelsymmetrisch ausgebildet.

Wie aus Figur 2 noch ergänzend hervorgeht, ist die Schutzhaube 31 mit Hilfe von Führungsschienen 32, 32', 32" aus der ausgezogen dargestellten Position in die strichpunktiert dargestellte Position 31a anhebbar, um den Zugang zur Beladestation zu ermöglichen. Die Vakuumkammer 1 ruht auf Stützen 33, 33', .... An die Vakuumkammer 1 sind Turbomolekularpumpen 34 und 35 angeschlossen, und für den schrittweisen Antrieb des Substrattransportring 6 ist ein Antriebsmotor 36 vorgesehen. Die Schrittweite ist jeweils bestimmt durch den Abstand den zwei benachbarte Ausnehmungen 67, 67', ... zueinander aufweisen, wobei der ensprechende Drehwinkel in Figur 3 mit α bezeichnet ist. Der Wandabschnitt 37 steht symbolisch für die Begrenzungswand eines Sauberraums.

In Figur 4 sind Einzelheiten der Vakuumkammer 1 deutlicher erkennbar, nämlich die Kammerdecke 2, der Kammerboden 3 und die Zargen 4 und 5. In der Kammerdecke 2 ist eine zylindrische Ausnehmung angeordnet, die mit ausreichendem Radialspiel von einem Schleusenkammeroberteil 38 durchdrungen wird.

Das Schleusenkammeroberteil 38 besitzt einen zylindrischen Innenraum 39 und am oberen Ende einen Flansch 40 mit einer Dichtfläche 40a, in die ein Dichtring 41 eingelegt ist. Das Oberteil 38 ist über einen Faltenbalg 42 vakuumdicht mit der Vakuumkammer 1 verbunden.

Das Schleusenkammer-Oberteil 38 besitzt außerdem eine untere Dichtfläche 40b, in die ein weiterer Dichtring 43 eingelegt ist.

Zur Schleusenstation 8 bzw. 9 gehört ferner ein dem Schleusenkammer-Oberteil 38 zugeordneter, angetriebener und den zylindrischen Innenraum 39 weitgehend ausfüllender Verdrängerkörper 44 mit einem Dichtrand 45. Der Verdrängerkörper ist über eine Verstelleinrichtung 46 mit einer Kugelpaarung 47 mit einer Kolbenstange 48 verbunden, die zu einem Antriebszylinder 49 gehört. Dieser ist seinerseits über eine Tragsäule 50 mit dem Flansch 40 verbunden, so daß eine einwandfreie Zentrierung des Verdrängerkörpers 44 in Bezug auf die Achse A₁ - A₁ der gesamten Schleusenstation gewährleistet ist. Mittels des Antriebszylinders 49 ist der Dichtrand 45 auf die obere Dichtfläche 40a bzw. den Dichtring 41 des Schleusenkammeroberteils vakuumdicht aufsetzbar.

Zwischen dem Flansch 40 und der Vakuumkammer 1 ist noch ein hier nicht sichtbarer Antrieb vorhanden, durch den die untere Dichtfläche 40b des Oberteils 38 abgedichtet auf der Oberseite des Substrattransportrings 6 abgesetzt wird.

Weiterhin besitzt die Schleusenstation 8 bzw. 9 ein Schleusenkammer-Unterteil 51, das als rohrförmiger Hohlkörper ausgebildet ist und eine Befestigungsflansch 52 für einen weiteren Faltenbalg 53 besitzt, der das Unterteil 51 konzentrisch umgibt und dieses vakuumdicht mit dem Kammerboden 3 verbindet. Zum Anschluß an den Kammerboden dient ein Überwurfring 54.

Das Unterteil 51 besitzt eine obere Dichtfläche 55, in die gleichfalls ein Dichtring 56 eingelegt ist. Unter Zwischenschaltung des Faltenbalges 53 ist das Unterteil 51 in Richtung der Achse A₁-A₁ begrenzt beweglich durch den Kammerboden 3 hindurchführt. Die koaxiale Vertikalbewegung wird durch einen Antriebszylinder 57 bewirkt, der über eine Tragsäule 58 an der Vakuumkammer 1 befestigt ist, und dessen Kolbenstange 59 auf das eine Ende einer gabelförmigen Schwinge 60 einwirkt, deren anderes Ende über eine Gelenkachse 61 mit dem Kammerboden 3 verbunden ist. Zwischen dem Angriffspunkt der Kolbenstange 59 und der Gelenkachse 61 ist die Schwinge 60 über eine weitere, hier nicht dargestellte Gelenkverbindung mit dem Schleusenkammer-Unterteil 51 verbunden, so daß bei einer Betätigung des Antriebszylinders 57 das Unterteil 51 angehoben oder abgesenkt werden kann. Im Innern des Schleusenkammer-Unterteils 51 befindet sich in koaxialer Anordnung eine Hubstange 62, die nach oben über die Dichtfläche 55 hinaus anhebbar und in Eingriff mit einer Substrataufnahme 63 bringbar ist, die in eine konzentrische Bohrung des Substrats 26 eingreift.

Mittels der Hubstange 62 und der Substrataufnahme 63 läßt sich das Substrat 26 zwischen der ausgezogen dargestellten Position und der strichpunktiert dargestellten Position bewegen. In der zuerst genannten Stellung ruht das Substrat 26 in einer flachen zylindrischen Ausnehmung des Substrathalters 6, wobei sich die Substrataufnahme 63 mittels eines nicht näher bezeichneten Flansches auf einer gleichfalls nicht näher bezeichneten Tragschulter des Substrattransportrings abstützt. In dieser Position läßt sich das Substrat 26 schrittweise durch die Vakuumkammer 1 hindruch transportieren. Die Verbindung der Hubstange 62 mit der Substrataufnahme 63 erfolgt beim Anheben der Hubstange 62 mittels eines Zentrierkegels 64, der in eine komplementäre Bohrung der Substrataufnahme 63 eingreift. Die obere Position des Substrats 26' ist diejenige Position, in der das Substrat in die Achse A₁ - A₁ eingeschwenkt und aus dieser wieder mittels der Greifer 22, 22' bzw. 23, 23' herausgeschwenkt werden kann (siehe Figur 1).

Das Schleusenkammer-Unterteil 51 ist über einen Saugstutzen 65 an eine Vakuumpumpe angeschlossen und über eine Flutleitung 66 belüftbar.

Zu Figur 4 wäre noch nachzutragen, daß die eingezeichneten Stellungen von Verdrängerkörper 44 einerseits und Schleusenkammer-Oberteil 38 und Schleusenkammer-Unterteil 51 andererseits während des Betriebes nicht gleichzeitig auftreten. Die eingezeichnete Stellung von Oberteil 38 und Unterteil 51 relativ zum Substrattransportrings 6 ist nur möglich, wenn sich der Verdrängerkörper 44 in der gestrichelten Position befindet, d.h. abgedichtet gegenüber dem Oberteil 38. Wenn sich der Verdrängerkörper 44 umgekehrt in der angehobenen Position 44 befindet, müssen die Dichtflächen 40b und 55 am Substrathalter anliegen, um das Eindringen von Umgebungsluft in die Vakuumkammer 1 zu verhindern.

Die Wirkungsweise der Vorrichtung sei im Zusammenhang erläutert:
Der Substrattransportring 6 wird mittels der beiden Schleusenstationen 8 und 9 mit Substraten 26, 26', ... beschickt, und zwar wird mittels der Schleusenstation 8 jeweils die erste, dritte, fünfte, siebte, ... Ausnehmung mit einem Substrat bestückt, während mittels der Schleusenstation 9 die zweite, vierte, sechste, achte, ... Ausnehmung 67, 67' mit einem Substrat bestückt wird. Die in den ungeradzahligen Ausnehmungen einerseits und in den geradzahligen Ausnehmungen andererseits liegenden Substrate bilden jeweils eine Folge. Das Einlegen der Substrate 26, 26', ... geschieht dadurch, daß jeweils ein Greifer 22, 22' ein Substrat von der jeweils zugehörigen Übergabeeinrichtung 20 bzw. 21 übernimmt und es nach dem Herumschwenken um die Drehachse 24 in die in Figur 4 gestrichelt dargestellte Position bringt. In dieser Stellung eines jeden Substrats dringt die Substrataufnahme 63, angehoben durch die Hubstange 62, mittels eines ringförmigen Fortsatzes von unten in eine kreisförmige Mittenausnehmung des Substrats ein und hält dieses zuverlässig fest.

In diesem Augenblick gibt der betreffende Greifer der Beladestation das Substrat frei, das nunmehr durch eine Absenkbewegung der Hubstange 62 in die in Figur 4 ausgezogen dargestellte Position gebracht wird. Unmittelbar, nachdem das Substrat 26 zur Auflage in der Ausnehmung 67 des Substrattransportrings 6 kommt, setzt sich auch die Substrataufnahme 63 auf der Ringschulter des Substrattransportrings 6 ab und der Zentrierkegel 64 trennt sich von der Substrataufnahme 63. Es versteht sich, daß hierbei - im Gegensatz zur zeichnerischen Darstellung in Figur 4 - eine Abdichtung zwischen dem Substrattransportring 6 und dem Schleusenkammer-Oberteil 38 einerseits und dem Schleusenkammer-Unterteil 51 andererseits besteht. Unmittelbar nach dem Absenken des Substrats 26 wird der Verdrängerkörper 44 in den Innenraum 39 oberhalb des Substrats 26 eingeführt (gestrichelt dargestellte Position), wobei sich eine Abdichtung zwischen der Dichtfläche 40a und dem Dichtrand 45 ergibt. Nunmehr werden - unter ständigem Betrieb der Vakuumpumpen - das Schleusenkammer-Oberteil 39 angehoben und das Schleusenkammer-Unterteil 51 abgesenkt. Diese Stellung ist in Figur 4 dargestellt. Jetzt ist die Vorrichtung in einem Betriebszustand in der der Substrattransportring 6 um eine Schrittweite, d.h. um 2 Teilungswinkel α, fortgeschaltet werden kann.

Sobald das betreffende Substrat 26 im Zuge seiner schrittweisen Fortschaltung in die Beschichtungsstation 10 gelangt und dort zum Stillstand gekommen ist, wird das Substrat mit dem von einem Target stammenden Material beschichtet.

Nach Beendigung des Beschichtungsvorganges wird das Substrat 26 wieder mit dem Substrattransportring 6 schrittweise fortgeschaltet, bis das fertig beschichtete Substrat wieder in die gleiche Schleusenstation 8 gelangt. Der Ausschleusvorgang des Substrats erfolgt genau umgekehrt wie der Einschleusvorgang, d.h. zunächst wird der Substrattransportring 6 gegenüber dem Schleusenkammer-Oberteil 38 und dem Schleusenkammer-Unterteil 51 abgedichtet, danach der Innenraum 39 geflutet und der Verdrängerkörper 44 angehoben. Unmittelbar nachfolgend wird auch das Substrat 26 mittels der Hubstange 62 in die strichpunktierte Position angehoben und von einem der Greifer 22,22' bzw. 23,23' erfaßt und aus dem Bereich um die Achse A₁-A₁ herausgeschwenkt. Wiederum unmittelbar nachfolgend wird ein neues, noch unbeschichtetes Substrat durch Drehung der Greifer um die Drehachse 24 in die gleiche Position eingeschwenkt, worauf sich der Einschleusvorgang in der weiter oben beschriebenen Weise wiederholt.

Wie Figur 1 zeigt, weist jede Übergabeeinrichtung 20, 21 jeweils acht Halter 85, 85', ... bzw. 86, 86', ... für acht Substrate 26, 26', ... auf, wobei die Substratteller 20a, 21a die jeweils um die Achsen 68, 68' drehbar gelagert sind, sich bei jedem Arbeitstakt um eine Substratposition, d.h. um den Winkel αweiterdrehen.

Bei jedem Arbeitstakt legen die Wendeeinrichtungen 28, 29 oder die Wendeeinrichtungen 28', 29' Substrate 26, 26', ... auf den Substrattellern 20a, 21a ab während die Wendeeinrichtungen 28", 29" bzw. 28"', 29"' Substrate 26, 26', ... von den Substrattellern 20a, 21a abnehmen und jeweils auf einen der Stapel 69, 70 der Magazine 25", 25"' bzw. 27", 27"' ablegen.

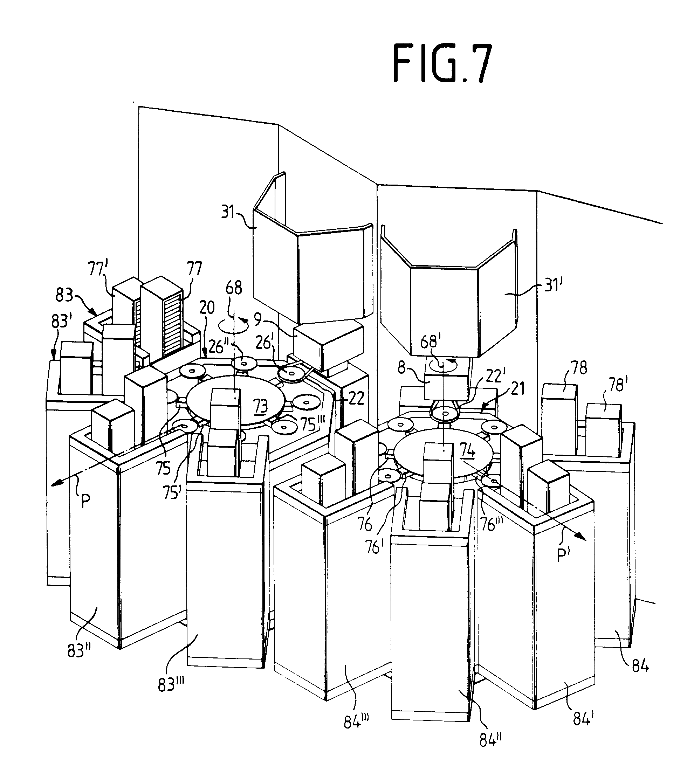

Anstelle eines Magazintyps mit jeweils zwei hintereinander angeordneten Stapeln 69, 70, die auf einem Träger 71 um eine Achse 72 schwenkbar gehalten sind, kann auch ein Magazintyp verwendet werden wie er in Figur 7 näher dargestellt ist und dessen beide Stapelkästen 77, 78 in verschiebbaren Einzelmagazinen angeordnet sind.

Figur 7 zeigt eine Vorrichtung mit vertikal verschiebbaren Stapelkästen 78, 78' bzw. 77, 77' und mit zwei Übergabeeinrichtungen 20, 21, bei denen oberhalb der Substratteller 20a, 21a, anstelle von Wendeeinrichtungen Substratverschiebeeinrichtungen 73, 74 vorgesehen sind, die mit sich in einer horizontalen Ebene bewegenden Armen 75, 75', ... bzw. 76, 76', ... ausgestattet sind, und die die Substrate 26, 26', ... in die Stapelkästen 77, 77', ... bzw. 78, 78', ... bzw. aus diesen heraus bewegen. Je nach dem, ob der außenstehende oder innenstehende Stapelkasten 77, 77', ... bzw. 78, 78', ... bedient werden soll, fährt der entsprechende Arm 75, 75', ... bzw. 76, 76', ... weiter oder weniger weit in radialer Richtung P, P'aus der Substrat-Verschiebeeinrichtung 73 bzw. 74 heraus.

### Auflistung der Einzelteile:

- 1: Vakuumkammer
- 2: Kammerdecke
- 3: Kammerboden
- 4: innere Zarge
- 5: äußere Zarge
- 6: Substrattransportring
- 7: Transportrichtung
- 8: Schleusenstation
- 9: Schleusenstation
- 10: Beschichtungsstation
- 11: Beschichtungsstation
- 12: Hubmechanismus
- 13: Ausleger
- 14: Führungsrohr
- 15: Hubzylinder
- 16: Beladestation
- 17: Beladestation
- 18, 18', ...: Magazin
- 19, 19', ...: Magazin
- 20: Übergabeeinrichtung
- 21: Übergabeeinrichtung
- 20a: Substratteller
- 21a: Substratteller
- 22, 22': Greifer
- 23, 23': Greifer
- 24, 24': Drehachse
- 25, 25', ...: Substratstapel
- 26, 26', ...: Substrat
- 27, 27', ...: Substratstapel
- 28, 28', ...: Wendeeinrichtung
- 29, 29', ...: Wendeeinrichtung
- 30, 30': Stoßdämpfer
- 31, 31': Schutzhaube
- 32, 32', ...: Führungsschiene
- 33, 33', ...: Stütze
- 34: Turbomolekularpumpe
- 35: Turbomolekularpumpe
- 36: Antriebsmotor
- 37: Wandabschnitt
- 38: Schleusenkammeroberteil
- 39: zylindrischer Innenraum
- 40: Flansch
- 40a: Dichtfläche
- 40b: Dichtfläche
- 41: Dichtung
- 42: Faltenbalg
- 43: Dichtring
- 44: Verdrängerkörper
- 45: Dichtrand
- 46: Verstelleinrichtung
- 47: Kugelpaarung
- 48: Kolbenstange
- 49: Arbeitszylinder
- 50: Tragsäule
- 51: Schleusenkammer-Unterteil
- 52: Befestigungsflansch
- 53: Faltenbalg
- 54: Überwerfung
- 55: Dichtfläche
- 56: Dichtung
- 57: Antriebszylinder
- 58: Tragsäule
- 59: Kolbenstange
- 60: Schwinge
- 61: Gelenkachse
- 62: Hubstange
- 63, 63', ...: Substrataufnahme
- 64: Zentrierkegel
- 65: Saugstutzen
- 66: Flutleitung
- 67, 67', ...: Ausnehmung
- 68, 68': Drehachse
- 69: Stapel
- 70: Stapel
- 71: Träger
- 72: Drehachse
- 73: Substratverschiebeeinrichtung
- 74: Substratverschiebeeinrichtung
- 75, 75', ...: Arm
- 76, 76', ...: Arm
- 77, 77', ...: Stapelkasten
- 78, 78', ...: Stapelkasten
- 80: horizontale Schwenkachse
- 81, 82: Greifer, Arm
- 79, 79', ...: Saugkopf
- 83, 83',...: Magazinhalter
- 84, 84',...: Magazinhalter
- 85, 85',...: Substrathalter
- 86, 86',...: Substathalter

## Patentansprüche

1. Vorrichtung nach dem Karussell-Prinzip zum Beschichten von flachen, im wesentlichen kreisscheibenförmigen Substraten (26 ,26', ...) mit einer Vakuumkammer (1) und einem in dieser angeordneten drehbaren Substrattransportring (6), der in gleichmäßigen Abständen und in kreisförmiger Anordnung eine Vielzahl von Substrataufnahmen (63, 63', ...) aufweist und durch den eine entsprechende Anzahl von Substraten (26, 26', ...) mittels eines Antriebs (36) schrittweise auf einer Kreisbahn von mindestens einer Schleusenstation (8, 9) über zugeordnete Beschichtungsstationen (10, 11) zur selben Schleusenstation (8, 9) zurücktransportierbar ist, wobei die Schrittweite des Antriebs (36), die sich jeweils aus dem Abstand von zwei benachbarten Ausnehmungen (67 und 67' bzw. 67' und 67") des Substrattransportrings (6) zueinander ergibt und der Abstand zweier Beschichtungsstationen (10, 11) so gewählt sind, daß ein und dieselbe Beschichtungsstation (10, 11) über die schrittweise Bewegung jeweils einer bestimmten Substrataufnahme (63, 63', ...) jeweils ein und derselben Schleusenstation (8, 9) zugeordnet ist und daß jeder Schleusenstation (8, 9) jeweils eine Übergabeeinrichtung (20, 21) mit jeweils einem drehbaren Substratteller (20a, 21a) mit Substrathaltern (85, 85', ... bzw. 86, 86', ...) zugeordnet ist, wobei jeder Substratteller (20a, 21a) jeweils mit mehreren Magazinen (18, 18', ... bzw. 19, 19', ...) oder Magazinhaltern (83, 83', ... bzw. 84, 84', ...) zusammenwirkt, wobei jedes Magazin bzw. jeder Magazinhalter mindestens zwei Stapel (69, 70) oder Stapelkästen (77, 77', ..., 78, 78', ...) mit Substraten (26, 26', ...) aufweist und wobei mit jedem der Magazine bzw. Magazinhalter oder Stapelkästenjeweils eine Wendeeinrichtung (28, 28', ... bzw. 29, 29', ...) oder Substrat-Verschiebeeinrichtung (73, 74) zusammenwirkt, die die Substrate von den Stapeln (69, 70) zu den Substrathaltern (85, 85', ...) der Substratteller (20a bzw. 21a) oder umgekehrt transportiert.

2. Vorrichtung nach Anspruch 1, **dadurch gekennzeichnet,** daß mit den Schleusenstationen (8, 9) Übergabeeinrichtungen (20, 21) zusammenwirken, denen jeweils um die Drehachsen (68, 68') rotierende Substratteller (20a, 21a) mit jeweils einer Vielzahl von Substrathaltern (85, 85', ... bzw. 86, 86', ...) zur Aufnahme von Substraten (26, 26', ...) zugeordnet sind, wobei die Substrathalter in gleichmäßigen Abständen voneinander und auf einem Kreisbogen angeordnet sind und mittels eines Antriebs schrittweise bewegbar sind.

3. Vorrichtung nach den Ansprüchen 1 und 2 , **dadurch gekennzeichnet,** daß jeder Übergabeeinrichtung (20, 21) mehrere, beispielsweise vier Stapel (18, 18', ... bzw. 19, 19', ...) bzw. Magazinhalter (83, 83', ... bzw. 84, 84', ...) zugeordnet sind, wobei jeder Magazinhalter mit einer Wendeeinrichtung (28, 28', ... bzw. 29, 29', ...) ausgestattet ist, deren Greifer oder Arme (81, 82) um eine horizontale Achse (80) schwenkbar und mit einem Saugkopf (79) zum Anheben und Ablegen der Substrate (26, 26', ...) ausgestattet ist.

4. Vorrichtung nach den Ansprüchen 1 und 2, **dadurch gekennzeichnet,** daß jeder Übergabeeinrichtung (20, 21) mehrere Magazinhalter (83, 83', ... bzw. 84, 84', ...) zugeordnet sind, von denen jedes zwei hintereinanderliegende Stapelkästen (77, 77', ... bzw. 78, 78', ...) aufweist, wobei oberhalb der Ebene der Substratteller (20a, 21a) der Übergabeeinrichtungen (20, 21) Substratverschiebeeinrichtungen (73, 74) angeordnet sind, deren Arme (75, 75', ... bzw. 76, 76', ...) in einer Ebene parallel zu derjenigen der Substratteller (20a, 21a) in radialer Richtung (P, P') von den Drehachsen (68, 68') aus, bis hin zu den Substratkästen (77, 77', ... bzw 78, 78', ...) der Magazinhalter (83, 83', ... bzw. 84, 84', ...) bewegbar sind, wobei die freien Enden der Arme mit Haltefingern oder Saugköpfen (79, 79') zum Aufnehmen der Substrate (26, 26', ...) ausgestattet sind.

5. Vorrichtung nach einem oder mehreren der vorgehenden Ansprüche, **dadurch gekennzeichnet,** daß die den Transport der Substrate (26, 26', ...) bewirkenden Teile der Vorrichtung, insbesondere der Substrattransportring (6), die Schleusenstationen (8, 9) mit ihren Greifern (22, 22' bzw. 23, 23'), die Substratteller (20a, 21a) und die Wendeeinrichtungen (28, 28', ... bzw. 29, 29', ...) oder die Substratverschiebeeinrichtungen (73, 74) zentral über einen elektrischen Schaltkreis synchron und im Gleichtakt ansteuerbar sind.

6. Vorrichtung nach einem oder mehreren der Ansprüche 1 bis 5, **dadurch gekennzeichnet,** daß die Bewegung der den Transport der Substrate (26, 26', ...) von den Magazinen (18, 18', ... bzw. 19, 19', ...) bzw. Magazinhaltern (83, 83', ... bzw. 84, 84', ...) zu den Substrathaltern (85, 85', ... bzw. 86, 86', ...) der Substratteller (20a, 21a) bewirkenden Wende- oder Verschiebeeinrichtungen (28, 29 bzw. 73, 74) schrittweise und synchron zur Bewegung des Substrattransportrings (6) erfolgt, wobei jedoch bei jedem Schaltschritt die Antriebsmotore von jeweils zwei der Wendeeinrichtungen (28, 28', ... bzw. 29, 29', ...) oder der Verschiebeeinrichtungen (73, 74) einer Übergabeeinrichtung (20, 21) abgeschaltet sind.

## Claims

1. A rotary device for coating flat substantially disc-shaped substrates (26, 26', ...) comprising a vacuum chamber (1) containing a rotatable substrate-conveying ring (6) bearing a number of substrate holders (63, 63', ...) uniformly spaced in a circle, the ring being adapted, via a drive (36), to return a corresponding number of substrates (26, 26', ...) stepwise on a circular track from at least one lock station (8, 9) via associated coating stations (10, 11) to the same lock station (8, 9), the step width of the drive, which is obtained from the distance between each pair of neighbouring recesses (67 and 67' or 67' and 67'') in the substrate conveying ring (6), and the distance between two coating stations (10, 11) being chosen so that one and the same coating station (10, 11), via the stepwise motion of a respective substrate holder (63, 63', ...) is associated with one and the same lock station (8, 9), and each lock station (8, 9) is associated with a transfer device (20, 21) comprising a rotatable substrate plate (20a, 21a) and substrate holders (85, 85', ... or 86, 86', ...), and each substrate plate (20a, 21a) co-operates with a number of respective magazines (18, 18', ... or 19, 19', ...) or magazine holders (83, 83', ... or 84, 84', ...), and each magazine or each magazine holder has at least two stacks (69, 70) or stack boxes (77, 77', ..., 78, 78;, ...) containing substrates (26, 26', ...) and each magazine or magazine holder or stack box co-operates with a turning device (28, 28', ... or 29, 29', ...) or substrate-shifting device (73, 74) which conveys the substrates from the stacks (69, 70) to the substrate-holders (85, 85', ...) on the plates (20a, 21a) or vice versa.

2. A device according to claim 1, characterised in that the lock stations (8, 9) co-operate with transfer devices (20, 21) each associated with substrate plates (20a, 21a) rotating around axes (68, 68') and comprising a number of holders (85, 85', ... or 86, 86', ...) for holding substrates (26, 26', ...), the holders being disposed at uniform distances from one another and on a circle and being movable stepwise by a drive.

3. A device according to claims 1 and 2, characterised in that each transfer device (20, 21) is associated with a number of stacks (18, 18', ... or 19, 19', ...) e.g. four stacks or magazine holders (83, 83', ... or 84, 84', ...), each magazine holder being-equipped with a turning device (28, 28', ... or 29, 29', ...) having grippers or arms (81, 82) which are pivotable around a horizontal axis (80) and are equipped with a suction head (79) for raising and depositing the substrates (26, 26', ...).

4. A device according to claims 1 and 2, characterised in that each transfer device (20, 21) is associated with a number of magazine holders (83, 83', ... or 84, 84', ...), each containing two successive stack boxes (77, 77', ... or 78, 78', ...), and substrate-shifting devices (73, 74) are disposed above the plane of the substrate holders (20a, 21a) belonging to the transfer devices (20, 21), the arms (75, 75', ... or 76, 76, ...) of the substrate shifting devices being movable in a plane parallel to the arms of the substrate plates (20a, 21a) in a radial direction (P, P') from the axes of rotation (68, 68') outwards to the substrate boxes (77, 77', ... or 78, 78', ...) on the magazine holders (83, 83', ... or 84, 84', ...), the free ends of the arms having holding fingers or suction heads (79, 79') for receiving the substrates (26, 26', ...).

5. A device according to one or more of the preceding claims, characterised in that the parts of the device for conveying the substrates (26, 26', ...), more particularly the substrate-conveying ring (6), the lock stations (8, 9) and grippers (22, 22', or 23, 23'), the substrate holders (20a, 21a) and the turning devices (28, 28', ... or 29, 29', ...) or the substrate shifting devices (73, 74) are adapted to be actuated centrally via an electronic switching circuit, in synchronism and in phase.

6. A device according to one or more of claims 1 to 5, characterised in that the motion of the turning or shifting devices (28, 29 or 73, 74) for conveying the substrates (26, 26', ...) from the magazines (18, 18', ... or 19, 19', ...) or magazine holders (83, 83', ... or 84, 84', ...) to the substrate holders (85, 85', ... or 86, 86', ...) on the substrate plates (20a, 21a) occurs in stepwise manner and in synchronism with the motion of the substrate-conveying ring (6), but during each step, the driving motors of two turning devices (28, 28', ... or 29, 29', ...) or of the shifting devices (73, 74) of a transfer device (20, 21) are switched off.

## Revendications

1. Dispositif conforme au principe du carrousel pour revêtir des substrats plats, sensiblement en forme de disque circulaire (26, 26',...), dispositif comportant une chambre sous vide (1) et un anneau rotatif (6) de transport des substrats qui est disposé dans cette chambre, qui présente, à distance régulière et en disposition circulaire, une pluralité de réceptacles pour substrat (63, 63',...) et au moyen duquel un nombre correspondant de substrats (26, 26'...) peut être transporté, pas à pas, au moyen d'un mécanisme d'entraînement (36), sur un chemin circulaire, depuis au moins une station de passage par écluse (8, 9), en passant par des stations de revêtement correspondantes (10, 11) pour revenir à la même station de passage par écluse (8, 9), dispositif dans lequel le pas du mécanisme d'entraînement (36), qui résulte respectivement de la distance, l'un de l'autre, de deux évidements voisins (67 et 67' ou 67' et 67") de l'anneau (6) de transport des substrats, ainsi que la distance entre deux stations de revêtement (10, 11) sont choisis de façon que, du fait du déplacement pas à pas de, chaque fois, un réceptacle pour substrat déterminé (63, 63',...), une seule et même station de revêtement (10, 11) corresponde respectivement à une seule et même station de passage par écluse (8, 9) et de façon qu'à chaque station de passage par écluse (8, 9) corresponde respectivement une installation de transfert (20, 21) comprenant respectivement un plateau rotatif porte-substrats (20a, 21a) avec des porte-substrat (85, 85',... ou 86, 86',...), dispositif dans lequel chaque plateau porte-substrats (20a, 21a) collabore effectivement avec plusieurs magasins (18, 18',... ou 19, 19',...) ou porte-magasin (83, 83',... ou 84, 84',...), dans lequel chaque magasin ou porte-magasin présente au moins deux piles (69, 70) ou caissettes empilables (77, 77',..., 78, 78',...) contenant des substrats (26, 26',...) et dans lequel, avec chacun des magasins ou des porte-magasin ou des caissettes empilables collabore une installation de retournement (28, 28',... ou 29, 29',...) ou une installation de coulissement (73, 74) des substrats qui transporte les substrats, depuis les piles (69, 70), jusqu'au porte-substrat (85, 85',...) des plateaux porte-substrats (20a ou 21a) ou inversement.

2. Dispositif selon la revendication 1, caractérisé par le fait qu'avec les stations de passage par écluse (8, 9) collaborent des installations de transfert (20, 21) auxquels correspondent respectivement des plateaux (20a, 21a) porte-substrats, tournant autour des axes de rotation (68, 68') et présentant chacun une pluralité de porte-substrat (85, 85',... ou 86, 86',...) pour recevoir des substrats (26, 26',...), dispositif dans lequel les porte-substrat sont disposés à distance régulière l'un de l'autre et sur un arc de cercle et peuvent se déplacer pas à pas au moyen d'un mécanisme d'entraînement.

3. Dispositif selon les revendications 1 et 2, caractérisé par le fait qu'à chaque installation de transfert (20, 21) correspondent plusieurs, par exemple quatre piles (18, 18',... ou 19, 19',...) ou porte-magasin (83, 83',... ou 84, 84',...), dispositif dans lequel chaque porte-magasin est équipé d'une installation de retournement (28, 28',... ou 29, 29',...), dont des pinces ou des bras (81, 82) peuvent pivoter autour d'un axe horizontal (80) et sont équipés d'une tête à ventouse (79) pour soulever et déposer le substrat (26, 26',...).

4. Dispositif selon les revendications 1 et 2, caractérisé par le fait qu'à chaque installation de transfert (20, 21) correspondent plusieurs porte-magasin (83, 83',... ou 84, 84',...), dont chacun présente deux caissettes empilables (77, 77',... ou 78, 78',...) disposées l'une derrière l'autre, dispositif dans lequel, au-dessus du plan des plateaux (20a, 21a) porte-substrats des installations de transfert (20, 21) sont disposées des installations (73, 74) de coulissement des substrats dont les bras (75, 75',... ou 76, 76',...) peuvent se déplacer, dans un plan parallèle à chacun des plateaux (20a, 21a) porte-substrats, en direction radiale (P, P'), depuis les axes de rotation (68, 68'), jusqu'aux caissettes de substrat (77, 77',... ou 78, 78',...) des porte-magasin (83, 83',... ou 84, 84',...), les extrémités libres des bras étant équipées de doigts de prise ou de têtes à ventouse (79, 79') pour recevoir les substrats (26, 26',...).

5. Dispositif selon une ou plusieurs des revendications précédentes, caractérisé par le fait que les parties du dispositif opérant le transport des substrats (26, 26',...), en particulier l'anneau (6) de transport des substrats, les stations de passage par écluse (8, 9) avec leurs pinces (22, 22' ou 23, 23'), les plateaux porte-substrats (20a, 21a) et les installations de retournement (28, 28',...) ou 29, 29'...) ou les installations de coulissement des substrats (73, 74) peuvent être commandés, par l'intermédiaire d'un circuit électrique, en synchronisme et en phase.

6. Dispositif selon une ou plusieurs des revendications 1 à 5, caractérisé par le fait que le mouvement des installations de retournement ou de coulissement (28, 29 ou 73, 74) opérant le transport des substrats (26, 26',...), depuis les magasins (18, 18',... ou 19, 19',..) ou les porte-magasin (83, 83',... ou 84, 84',...) jusqu'au porte-substrat (85, 85',... ou 86, 86'...) des plateaux porte-substrats (20a, 21a) se fait pas à pas en synchronisme avec le mouvement de l'anneau (6) de transport des substrats, étant précisé toutefois qu'à chaque pas d'avancement les moteurs d'entraînement de, chaque fois deux des installations de retournement (28, 28',... ou 29, 29',...) ou les installations de coulissement (73, 74) d'une installation de transfert (20, 21) sont mis hors circuit.
